# EUROPEAN PATENT APPLICATION

(11) **EP 2 184 771 A1**
(43) Date of publication of application: **12.05.2010**
(21) Application number: 08792453.6
(22) Date of filing: 14.08.2008
(51) Int. Cl.: H01L 21/312, H01L 21/768, H01L 23/522

(54) **INTERLAYER INSULATION FILM AND WIRING STRUCTURE, AND THEIR MANUFACTURING METHOD**

(30) Priority: 16.08.2007 JP 2007212504
(71) Applicant: National University Corporation Tohoku University, Sendai-shi Miyagi 980-8577 (JP); Tokyo Electron Limited, Tokyo 107-6325 (JP); Ube Industries, Ltd., Ube-shi Yamaguchi 755-8633 (JP); UBE Nitto Kasei Co., Ltd., Tokyo 103-0004 (JP)
(72) Inventor: OHMI, Tadahiro, Sendai-shi Miyagi 980-8577 (JP); MATSUOKA, Takaaki, Tokyo 107-6325 (JP); INOKUCHI, Atsutoshi, Tokyo 107-6325 (JP); WATANUKI, Kohei, Tokyo 105-8449 (JP); KOIKE, Tadashi, Tokyo 103-0004 (JP); ADACHI, Tatsuhiko, Tokyo 103-0004 (JP)
(74) Representative: Goddar, Heinz J.
(86) International application number: PCT/JP2008/064572
(87) International publication number: WO 2009/022718

(57) **Abstract**

An insulative coat film comprising one or two or more kinds of oxides having a dielectric constant (k) of 2.5 or smaller and expressed by a general formula of ((CH₃)ₙSiO_{2-n/2})ₓ(SiO₂)₁₋ₓ (where n=1 to 3, x≤1) is used to form an interlayer insulation film. The insulative coat film applied by spin-coating is flat without reflecting underlying unevenness, and the heat-treated film has surface roughness of 1 nm or less in Ra and 20 nm or less in a P-V value. The interlayer insulation film containing the insulative coat film can have a wiring structure and an electrode formed only by etching without need of a CMP process.

## Description

### Technical Field

This invention relates to a multilayer wiring structure, particularly an interlayer insulating film structure, of a board such as a semiconductor element or semiconductor chip mounting board or a wiring board and further relates to a semiconductor device having the multilayer wiring structure, a wiring board having the multilayer wiring structure, and an electronic device including them. Moreover, this invention relates to a method of manufacturing the multilayer wiring structure and methods of manufacturing the semiconductor device having the multilayer wiring structure, the wiring board having the multilayer wiring structure, and the electronic device including them.

### Background Art

Conventionally, an interlayer insulating film is formed for insulation between wiring layers in a multilayer wiring structure on a semiconductor substrate or the like.

In a semiconductor device employing such a multilayer wiring structure, a problem of signal delay due to the parasitic capacitance between wirings and the wiring resistance has become unignorable and it has been required to use an interlayer insulating film having a low permittivity (Low-k).

As a low permittivity (Low-k) material of this type, attention has been paid to a fluorocarbon film. Patent Document 1 proposes a fluorocarbon film that can be used as an interlayer insulating film. Patent Document 1 discloses that the film density can be controlled by forming an interlayer insulating film made of a fluorocarbon polymer using a film forming gas having one or more double bonds or one triple bond. Further, it discloses that a fluorocarbon-based film forming gas with a molecular structure having one double bond is easily dissociated in a plasma and thus can form a high-density flat film. On the other hand, it discloses that a fluorocarbon polymer film formed using a film forming gas with a molecular structure having a triple bond is a film having both high-density properties and hard properties.

On the other hand, Patent Document 2 proposes a fluorocarbon film having a very low dielectric constant k as a material of an interlayer insulating film. Specifically, Patent Document 2 discloses an interlayer insulating film in the form of a fluorocarbon film having a dielectric constant k reduced to 1.5 to 2.2 by containing nitrogen. For this, Patent Document 2 makes it clear that F and C are contained in a range of 0.8 to 1.1 in atomic ratio F/C and, further, nitrogen is contained by 0.1 to 10at%. It is expected that the parasitic capacitance between wirings can be reduced by using such a fluorocarbon film as an interlayer insulating film.

- Patent Document 1:: JP-A-2002-220668
- Patent Document 2:: Japanese Patent Application No. 2007-38584

### Disclosure of the Invention

### Problem to be Solved by the Invention

A fluorocarbon film is, because of its low permittivity, expected to be used in a wiring structure on a semiconductor element, particularly as an interlayer insulating film in a wiring structure including the interlayer insulating film, which is as described above. Under these circumstances, Patent Document 1 discloses that a flat high-density film can be formed by selecting a film forming gas, but fails to show a specific example in which a fluorocarbon film is actually applied to an interlayer insulating film of a semiconductor device. Therefore, Patent Document 1 points out nothing about a specific problem in the case where a fluorocarbon film is actually used as an interlayer insulating film.

On the other hand, Patent Document 2 shows an example in which an interlayer insulating film is formed by a fluorocarbon film. However, it has been found that when the interlayer insulating film is actually formed by the fluorocarbon film, the flatness required for the interlayer insulating film is not obtained.

Specifically, it has been found that when the interlayer insulating film is formed by the fluorocarbon film, the surface of the fluorocarbon film becomes a rough surface with unevenness and thus cannot obtain sufficient properties as the interlayer insulating film. Actually, the flatness of the surface of the fluorocarbon film is about 1.72nm in Ra value and about 17.94nm in P-V (peak-to-valley) value and, if nitrogen (N) is added for further reducing the permittivity, the flatness is further degraded. When a barrier film is formed on this fluorocarbon film, it has a surface reflecting the rough surface with unevenness of the fluorocarbon film. Further, a normal barrier film has k of 4.0 or more and, therefore, a barrier film with smaller k is required for reducing the total permittivity of the interlayer insulating film.

Therefore, it is a technical object of this invention to provide an interlayer insulating film of a semiconductor device or the like, which can realize excellent flatness and has a low permittivity and which can be formed with high reproducibility and thus is stable, and to provide a wiring structure including such an interlayer insulating film.

It is another technical object of this invention to provide methods of manufacturing the above-mentioned interlayer insulating film and the above-mentioned wiring structure.

### Means for Solving the Problem

According to a first aspect of this invention, there is provided an interlayer insulating film provided between a lower electrode or wiring layer and an upper wiring layer, said interlayer insulating film including, at least at a part thereof, a coated insulative film having a dielectric constant k of 2.5 or less.

According to a second aspect of this invention, there is provided an interlayer insulating film provided between a lower electrode or wiring layer and an upper wiring layer, said interlayer insulating film including a fluorocarbon film as a main insulating film, wherein a coated insulative film is provided on said fluorocarbon film.

According to a third aspect of this invention, there is provided an interlayer insulating film according to the second aspect, wherein said fluorocarbon film contains F and C in a range of 0.8 to 1.1 in atomic ratio F/C.

According to a fourth aspect of this invention, there is provided an interlayer insulating film according to the second or the third aspect, wherein said fluorocarbon film has a dielectric constant k of 1.8 to 2.2.

According to a fifth aspect of this invention, there is provided an interlayer insulating film according to any one of claims 2 to 4, wherein said fluorocarbon film has a thickness of 50 to 500nm.

According to a sixth aspect of this invention, there is provided an interlayer insulating film according to any one of the second to the fifth aspects, wherein said coated insulative film has a thickness that is 1 /10 or less of that of said fluorocarbon film.

According to a seventh aspect of this invention, there is provided an interlayer insulating film according to any one of the second to the fifth aspects, wherein said coated insulative film has a thickness that is 1/5 or less of that of said fluorocarbon film.

According to an eighth aspect of this invention, there is provided an interlayer insulating film according to any one of the second to the fifth aspects, wherein said coated insulative film has a thickness that is 1/3 or less of that of said fluorocarbon film.

According to a ninth aspect of this invention, there is provided an interlayer insulating film according to any one of the second to the eighth aspects, wherein said fluorocarbon film is formed by CVD using at least one kind of gas containing C and F in a plasma generated using at least one of an Ar gas, a Xe gas, and a Kr gas.

According to a tenth aspect of this invention, there is provided an interlayer insulating film according to the first aspect, wherein said coated insulative film is a main insulating film.

According to an eleventh aspect of this invention, there is provided an interlayer insulating film according to any one of the second to the ninth aspects, wherein said coated insulative film has a dielectric constant k of 2.5 or less.

According to a twelfth aspect of this invention, there is provided an interlayer insulating film according to any one of the first to the eleventh aspects, wherein said coated insulative film has a surface flatness of 1 nm or less in Ra and 20nm or less in peak-to-valley value.

According to a thirteenth aspect of this invention, there is provided an interlayer insulating film according to any one of the first to the twelfth aspects, wherein said coated insulative film contains Si, C, and O so that O>Si>1/2C in atomic ratio.

According to a fourteenth aspect of this invention, there is provided an interlayer insulating film according to any one of the first to the thirteenth aspects, wherein said coated insulative film is a film obtained by drying and baking a liquid coating film containing at least one of a metal organic compound and a metal inorganic compound and a solvent.

According to a fifteenth aspect of this invention, there is provided an interlayer insulating film according to any one of the first to the thirteenth aspects, wherein said coated insulative film is a film obtained by drying and baking at 600ºC or less a liquid coating film containing at least one of a metal organic compound and a metal inorganic compound and a solvent.

According to a sixteenth aspect of this invention, there is provided an interlayer insulating film according to any one of the first to thirteenth aspects, wherein said coated insulative film is a film obtained by drying and baking at 400ºC or less a liquid coating film containing at least one of a metal organic compound and a metal inorganic compound and a solvent.

According to a seventeenth aspect of this invention, there is provided an interlayer insulating film according to any one of the first to the sixteenth aspects, wherein said coated insulative film is an insulator film which has a main skeleton specified by a repetition unit of SiO and which has a composition comprising one kind or two or more kinds of oxides expressed by a general formula of ((CH₃)ₙSiO_{2-n/2})ₓ(SiO₂)₁₋ₓ (where n=1 to 3 and x≤1).

According to an eighteenth aspect of this invention, there is provided an interlayer insulating film according to any one of the first to the seventeenth aspects, wherein said coated insulative film has a nitride surface layer formed by nitriding a surface thereof.

According to a nineteenth aspect of this invention, there is provided a multilayer wiring structure having the interlayer insulating film according to any one of the first 1 to the eighteenth aspects, said multilayer wiring structure comprising at least one of a via and a trench in said interlayer insulating film, a conductor layer buried in said at least one of said via and said trench, and a barrier layer provided around said conductor layer.

According to a twentieth aspect of this invention, there is provided a multilayer wiring structure having an interlayer insulating film, wherein said interlayer insulating film includes an insulator film obtained from a coating film comprising one kind or two or more kinds of oxides expressed by a general formula of ((CH₃)ₙSiO_{2-n/2})ₓ(SiO₂)₁₋ₓ (where n=1 to 3 and x≤1).

According to a twenty-first aspect of this invention, there is provided a multilayer wiring structure according to the twentieth aspect, wherein said interlayer insulating film comprises said insulator film and a fluorocarbon film (CFx).

According to a twenty-second aspect of this invention, there is provided
a multilayer wiring structure according to the twentieth aspect of thie invention wherein said interlayer insulating film is formed by said insulator film.

According to a twenty-third aspect of this invention, there is provided a multilayer wiring structure including a plurality of interlayer insulating films, wherein at least one of said plurality of interlayer insulating films includes an insulator film obtained from a coating film comprising one kind or two or more kinds of oxides expressed by a general formula of ((CH₃)ₙSiO_{2-n/2})ₓ(SiO₂)₁₋ₓ (where n=1 to 3 and x≤1).

According to a twenty-fourth aspect of this invention, there is provided a method of manufacturing an interlayer insulating film, said method comprising coating a liquid material containing one kind or two or more kinds of oxides expressed by a general formula of ((CH₃)ₙSiO_{2-n/2})ₓ(SiO₂)₁₋ₓ (where n=1 to 3 and x≤1) and drying a film thus coated, thereby forming the interlayer insulating film including an insulator film having a dielectric constant k of 2.5 or less.

According to a twenty-fifth aspect of this invention, there is provided a manufacturing method of forming a multilayer wiring structure including an interlayer insulating film, wherein a step of forming said interlayer insulating film comprises a step of coating a liquid material containing one kind or two or more kinds of oxides expressed by a general formula of ((CH₃)ₙSiO_{2-n/2})ₓ(SiO₂)₁₋ₓ (where n=1 to 3 and x≤1) and drying a film thus coated, thereby forming said interlayer insulating film including an insulator film having a dielectric constant k of 2.5 or less.

According to a twenty-sixth aspect of this invention, there is provided an electronic device including an interlayer insulating film, wherein said interlayer insulating film is an insulator film obtained from a coating film comprising one kind or two or more kinds of oxides expressed by a general formula of ((CH₃)ₙSiO_{2-n/2})ₓ(SiO₂)₁₋ₓ (where n=1 to 3 and x≤1).

According to a twenty-seventh aspect of this invention, there is provided a method of manufacturing an electronic device including an interlayer insulating film, wherein a step of forming said interlayer insulating film comprises a step of coating a liquid material containing one kind or two or more kinds of oxides expressed by a general formula of ((CH₃)ₙSiO_{2-n/2})ₓ(SiO₂)₁₋ₓ (where n=1 to 3 and x≤1) and drying a film thus coated, thereby forming said interlayer insulating film including an insulator film having a dielectric constant k of 2.5 or less.

### Effect of the Invention

According to this invention, since an interlayer insulating film is formed by coating a liquid coating film and then drying it, its surface can be maintained extremely flat so that flattening by a CMP process can be made unnecessary in subsequent processing.

### Brief Description of the Drawings

Fig. 1 is a sectional view showing a multilayer wiring structure according to one embodiment of this invention.
Fig. 2 is a schematic sectional view showing a microwave-excited plasma processing apparatus for use in the manufacture of the multilayer wiring structure shown in Fig. 1.
Fig. 3 is a sectional view for explaining a multilayer wiring structure according to another embodiment of this invention.
Fig. 4 is a sectional view for explaining a multilayer wiring structure according to still another embodiment of this invention.
Fig. 5 is a sectional view for explaining one example of a semiconductor device including interlayer insulating films according to an embodiment of this invention.
Fig. 6 is a sectional view for explaining another example of a semiconductor device including interlayer insulating films according to an embodiment of this invention.

### Description of Symbols

- 1: barrier cap layer
- 2: first interlayer insulating film
- 3: first adhesive layer
- 4: second interlayer insulating film
- 5: second adhesive layer
- 6: hard mask
- 121: fluorocarbon film (CFx film)
- 122: coated insulative film
- 141: fluorocarbon film
- 142: coated insulative film
- 7: via hole
- 7', 9': barrier layer
- 8: electrode
- 9: trench
- 10, 20: multilayer wiring structure
- 11: wiring conductor (Cu)
- 21: barrier cap layer
- 22: interlayer insulating film formed of SiCO
- 25: barrier layer
- 27: via hole
- 28: wiring
- 29: trench
- 27': barrier layer
- 28': wiring conductor
- 29': barrier layer
- 30: plasma processing apparatus
- 31: insulator plate
- 32: antenna
- 33: upper shower plate
- 34: plasma generating region
- 35: lower shower plate
- 37: process chamber
- 41: microwave
- 43: gas introducing pipe

### Best Mode for Carrying Out the Invention

Hereinbelow, embodiments of this invention will be described with reference to the drawings.

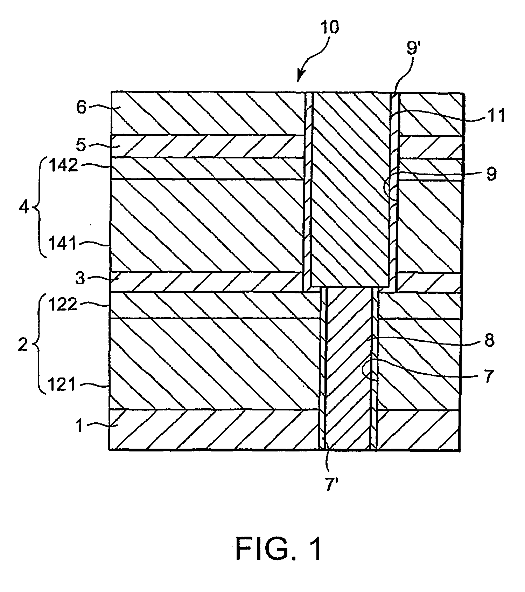

Fig. 1 is a sectional view showing a wiring structure according to one embodiment of this invention. A semiconductor device shown in Fig. 1 has a multilayer wiring structure (only one connecting portion between wiring layers is shown) 10 provided over a semiconductor substrate (not shown) formed with a number of semiconductor elements. The illustrated multilayer wiring structure 10 is provided on a barrier cap layer 1 made of silicon carbonitride (SiCN) and provided on the semiconductor substrate and includes first and second interlayer insulating films 2 and 4, wherein these interlayer insulating films 2 and 4 insulate wiring layers and/or conductive regions formed in multilayers from each other.

The first interlayer insulating film 2 is provided with a via hole 7 penetrating the first interlayer insulating film 2 and the barrier cap layer 1. An electrode or wiring 8 made of Cu is formed in the via hole 7. Further, a second interlayer insulating film 4 in the form of a fluorocarbon film is formed on the first interlayer insulating film 2 through a first adhesive layer 3 made of SiCN. A hard mask 6 made of silicon oxide (SiO₂) is provided on the second interlayer insulating film 4 through a second adhesive layer 5 made of SiCN.

Further, a trench 9 is provided from the hard mask 6 to the first interlayer insulating film 2 and a wiring conductor 11 made of Cu is buried in this trench. On inner walls of the via hole 7 and the trench 8, barrier layers 7' and 9' made of NiF₂ and forming a barrier to Cu forming the wiring conductors 8 and 11 are formed.

Herein, SiCN of the barrier cap layer 1 and the first and second adhesive layers 3 and 5 has a dielectric constant k of 4.0 to 4.5. Alternatively, a hydrocarbon film with k smaller than 3.0 may be used as each of the barrier cap layer 1 and the adhesive layers 3 and 5 or a thinner SiCO film with k=3.0 may be used as each of the adhesive layers 3 and 5. Herein, as hydrocarbon with k=3.0 or less, there is cited an amorphous carbon film (CHy:y=0.8 to 1.2) with a thickness of 20 to 30nm formed from butyne and an Ar plasma. Although the permittivity increases, SiN, SiC, SiO₂, or the like may of course be used as the barrier cap layer 1 and the adhesive layers 3 and 5.

Further, although the SiO₂ film with k=4.0 is used as the hard mask layer 6, it is alternatively possible to use a SiCO film with k smaller than 3.0. Alternatively, the hard mask 6 can be formed of hydrocarbon with k=3.0 or less. For example, as this type of hydrocarbon, the above-mentioned hydrocarbon film is cited.

The first interlayer insulating film 2 shown in Fig. 1 is formed by a fluorocarbon (hereinafter referred to as CFx) film 121 and a coated insulative film 122 formed on the CFx film 121 and, likewise, the second interlayer insulating film 4 is formed by a CFx film 141 and a coated insulative film 142 formed on this CFx film.

Herein, the CFx films 121 and 141 forming the first and second interlayer insulating films 2 and 4 are each in the form of a fluorocarbon (CFx) film with k=2.0 and may contain nitrogen. The dielectric constant k of each of the CFx films 121 and 141 is preferably in a range of 1.8 to 2.2.

Further, the coated insulative films 122 and 142 forming the first and second interlayer insulating films 2 and 4 are each formed by coating a mixed agent containing a coating agent on the CFx film 121, 141 by spin coating and drying (heating and baking) it. Surfaces of the coated insulative films 122 and 142 coated and dried each have Ra of 1 nm or less. The peak-to-valley (P-V) value in this case is 20nm or less.

In this example, the coated insulative films 122 and 142 are each formed by coating the mixed agent containing the coating agent, a solvent, and other components on the CFx film 121, 141 by spin coating.

As an example of each of the coated insulative films 122 and 142, there is cited a liquid coating film containing a coating agent comprising at least one of a metal organic compound and a metal inorganic compound and a solvent. In this case, as the solvent, there can be exemplified an alcohol-based solvent such as methanol or ethanol, a ketone-based solvent such as methyl ethyl ketone or methyl isobutyl ketone, a glycol ester-based solvent such as ethylene glycol monoethyl ether or propylene glycol monomethyl ether, water, or the like, while, as the coating agent, use can be made of a compound containing C, Si, and O in the form of CₓSiO_{y} (x is a value of 0 or more and 2 or less and y is 2-x/2). In this compound, repeating SiO units form the main skeleton.

Herein, as a specific example of each of the coated insulative films 122 and 142 forming the first and second interlayer insulating films 2 and 4, there is cited (CH₃SiO_{3/2})ₓ(SiO₂)₁₋ₓ with a dielectric constant k of 2.4. Hereinafter, (CH₃SiO_{3/2})ₓ(SiO₂)₁-ₓ will be briefly referred to as a SiCO coating film. As is clear from the above-mentioned formula, the atomic ratio of Si, C, and O in the SiCO coating film is O>Si>1/2C.

The thickness of each of the CFx films 121 and 141 included in the first and second interlayer insulating films 2 and 4 is 50 to 500nm, while the thickness of each of the coated insulative films 122 and 142 coated on these CFx films 121 and 141 is smaller than that of the CFx film and is, for example, 1/3 or less, preferably 1/5 or less, and more preferably 1 /10 or less of that of the CFx film 121, 141.

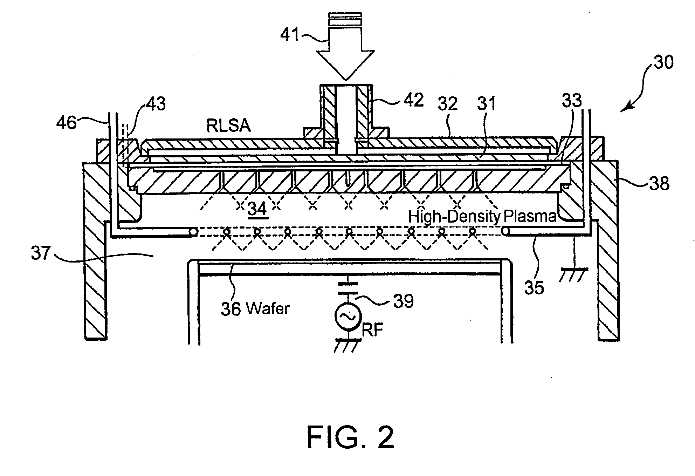

Referring to Fig. 2, a description will be given of a microwave-excited plasma processing apparatus 30 for use in the formation of the CFx films 121 and 141 of the interlayer insulating films 2 and 4 shown in Fig. 1. In Fig. 2, a microwave 41 is applied through a waveguide 42 to a radial line slot antenna (RLSA) 32 disposed through an insulator plate 31 at an upper portion of a chamber wall 38 of the plasma processing apparatus 30 and, further, is radiated from the RLSA 32 and transmitted through the underlying insulator plate 31 and an upper shower plate 33 into a plasma generating region 34. As a plasma excitation gas for plasma excitation, a noble gas such as an Ar gas (or Kr gas or Xe gas) is uniformly ejected into the plasma generating region 34 from the upper shower plate 33 through a gas introducing pipe 43, so that a plasma is excited by the microwave radiated into the plasma generating region 34.

A lower shower plate 35 is disposed in a diffusion plasma region of the illustrated microwave-excited plasma processing apparatus 30. Under the lower shower plate 35, a workpiece (herein, a wafer 36) is placed on a stage.

Herein, if a Kr, Xe, or Ar gas is caused to flow from the upper shower plate 33 and a CxFy (C₅F₈, C₄F₈, or the like) gas is caused to flow from the lower shower plate 35, a fluorocarbon film can be formed on the wafer 36. Exhaust gases in a process chamber 37 pass through an exhaust duct via non-illustrated exhaust ports so as to be introduced into a pump.

After removing the wafer formed with the CFx film 121 by the microwave-excited plasma processing apparatus 30 as described above from the microwave-excited plasma processing apparatus 30, the mixed agent containing the above-mentioned coating agent is coated on the formed CFx film 121 by spin coating and then baked at a temperature of 400ºC or the like to form the coated insulative film 122, thereby forming the first interlayer insulating film 2.

Subsequently, as shown in Fig. 1, the via hole 7 is formed by etching the underlayer 1 as a barrier cap layer and the first interlayer insulating film 2. Then, as the barrier layer 7' for preventing diffusion of the electrode metal into the interlayer insulating film, a film of a fluoride of nickel, preferably a nickel difluoride (referred to as NiF₂) film is formed on the inner wall of the via hole 7 by forming a film of nickel by PVD and then fluorinating it, or is directly formed thereon by MOCVD.

Then, a SiCN layer is formed as the underlayer 3 in the form of an adhesive layer and, thereon, the second interlayer insulating film 4 comprising the CFx layer 141 and the insulating coating layer 142 is formed.

The CFx film 141 forming the second interlayer insulating film 4 is formed by the microwave-excited plasma processing apparatus shown in Fig. 2, while the coated insulative film 142 is formed by spin-coating and baking the SiCO-coating-film coating agent containing the coating agent and so on like the coated insulative film 122.

Then, a SiCN layer or a SiCO layer is formed as the underlayer 5 for adhesion on the second interlayer insulating layer 4 and, on the underlayer 5, a SiO₂ or SiCO layer is formed as the hard mask layer 6. Herein, the SiO₂ layer can be formed by introducing a mixed gas of Ar and O₂ from the upper shower plate 33 and introducing a SiH₄ gas from the lower shower plate 35 in the plasma processing apparatus 30 shown in Fig. 2. The adhesive layers 3 and 5 may be omitted. In this case, the SiCO coating films 122 and 142 also serve as adhesive layers.

Further, the trench 9 is formed by etching to the multilayer wiring structure 10, the NiF₂ barrier layer 9' is formed on the inner wall surface of the trench 9, and Cu is filled as a metal in the trench 9 to form the wiring conductor 11, so that the wiring structure 10 is completed.

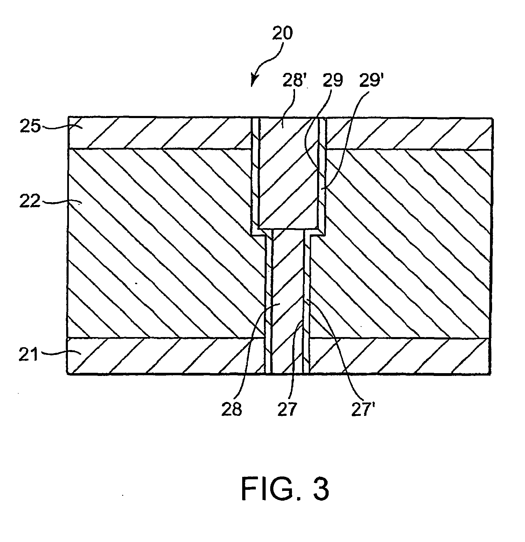

Fig. 3 is a sectional view showing a multilayer wiring structure according to another embodiment of this invention, wherein there is shown a multilayer wiring structure more simplified than the multilayer wiring structure shown in Fig. 1. Like Fig. 1, Fig. 3 shows only a part of the multilayer wiring structure provided over a semiconductor substrate (not shown) formed with a number of semiconductor elements.

The illustrated multilayer wiring structure 20 has an interlayer insulating film 22 in the form of a coated insulative film on a barrier cap layer 21 in the form of a hydrocarbon CH_{y} layer [y=0.8 to 1.2]. Further, another barrier layer 25 is formed on the interlayer insulating film 22. In this embodiment, a hydrocarbon CH_{y} layer [y=0.8 to 1.2] is used as the barrier layer 25. As each of the barrier cap layer 21 and the barrier layer 25, use can be made of a layer formed of any of various materials not limited to the above-mentioned hydrocarbon.

As shown in Fig. 3, a via hole 27 is provided so as to penetrate the barrier cap layer 21 and the lower part of the interlayer insulating film 22. An electrode or wiring 28 made of Cu is formed in the via hole 27. A trench 29 is provided so as to penetrate the remainder (upper part) of the interlayer insulating film 22 and the barrier layer 25 and a wiring conductor 28' made of Cu is buried in the trench 29.

Herein, the hydrocarbon layers (i.e. CH_{y} layers) forming the barrier cap layer 21 and the barrier layer 25 each have a dielectric constant k of 3.0 or less.

The coated insulative film forming the illustrated interlayer insulating film 22 is preferably formed by a coated insulative film having a dielectric constant k of 2.5 or less like the coated insulative films 122 and 142 shown in Fig. 1. Therefore, as the interlayer insulating film 22 formed by the coated insulative film, it is preferable to use the above-mentioned SiCO coating film having a dielectric constant k of 2.4 and expressed by a general formula of ((CH₃)ₙSiO_{2-n/2})ₓ(SiO₂)₁₋ₓ (where n=1 to 3 and x≤1).

As described above, in this embodiment, since the interlayer insulating film 22 is formed only by the coated insulative film having the small dielectric constant k and high flatness, it is possible to significantly reduce the dielectric constant k as compared with the conventional interlayer insulating films. Further, since Ra defining the flatness of the coated insulative film can be set to 1 nm or less, it is also possible to significantly improve the flatness on the surface of the interlayer insulating film 22. Therefore, the flatness of an electrode, an element, or the like stacked over the interlayer insulating film 22 can be maintained. Further, since the interlayer insulating film 22 is formed by the single layer of the coated insulative film, the illustrated embodiment also has an advantage that the manufacturing processes can be simplified as compared with the multilayer wiring structure shown in Fig. 1.

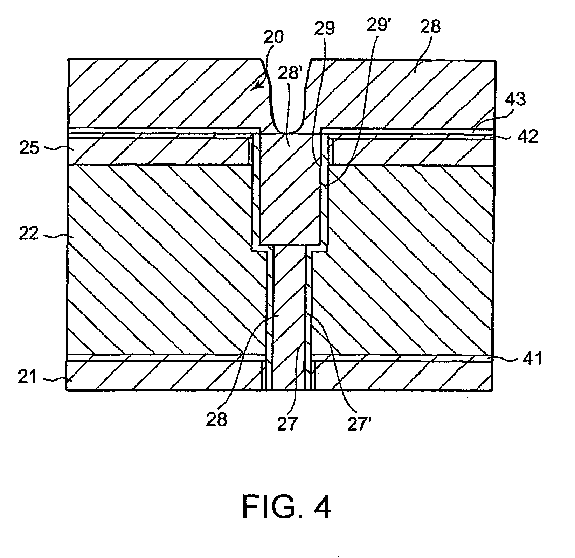

Referring to Fig. 4, a description will be given of a multilayer wiring structure according to another embodiment of this invention. The illustrated multilayer wiring structure comprises a barrier cap layer 21 in the form of a SiCO coating film provided on a lower wiring structure, an interlayer insulating film 22 provided on the barrier cap layer 21, and another barrier layer 25 formed on the interlayer insulating film 22. In this embodiment, the barrier layer 25 is also formed by the above-mentioned coated insulative film (i.e. a SiCO coating film), while the illustrated interlayer insulating film 22 is formed of fluorocarbon (CFx).

Further, as illustrated, a via hole 27 is provided so as to penetrate the barrier cap layer 21 and the interlayer insulating film 22 (lower part). An electrode or wiring 28 made of Cu is formed in the via hole 27. A trench 29 is provided so as to penetrate the remainder (upper part) of the interlayer insulating film 22 and the barrier layer 25 and a wiring conductor 28' made of Cu is buried in the trench 29. Further, barrier layers 27' and 29' are formed on inner walls of the via hole 27 and the trench 29.

Further, in the illustrated example, a surface of and an inner wall, exposed to the via hole 27, of the barrier layer 21 formed with the via hole 27 are covered with a surface nitrided film 41 formed by nitriding the surface of the SiCO coating film 21. On the other hand, a surface of and an inner wall, exposed to the trench 29, of the barrier layer 25 formed by the coated insulative film (SiCO coating film) are also covered with a surface nitrided film 42 formed by nitriding the surface of the SiCO coating film 25 and, further, a porous coated insulative film 43 in the form of a porous SiCO coating film is provided on an upper surface of the surface nitrided film 42.

The illustrated multilayer wiring structure is formed in the following manner. First, the SiCO coating film 21 is provided by coating and baking a coating solution and, by nitriding its surface, the surface nitrided film 41 with a thickness of 3 to 5nm is formed. After forming the surface nitrided film 41, the interlayer insulating film 22 made of fluorocarbon (CFx) is formed by the above-mentioned plasma CVD, then, on its surface, the barrier layer 25 in the form of the SiCO coating film is formed by coating a SiCO coating solution and baking it at 400ºC, and then, by nitriding its surface, the surface nitrided film 42 with a thickness of 3 to 5nm is formed. Thereon, the porous coated insulative film 43 in the form of the porous SiCO coating film is formed to a thickness of about 0.7 to 1.3µm.

Then, the trench 29 and the via hole 27 are formed through the porous coated insulative film 43, the barrier layer 25, the interlayer insulating film 22, and the barrier layer 21 and the side surfaces, exposed at the inner walls of the trench 29 and the via hole 27, of the barrier layers 25 and 21 are nitrided to thereby form the surface nitrided films each with a thickness of 3 to 5nm. Then, the barrier layers 27' and 29' are formed on the inner walls of the via hole 27 and the trench 29 like in the above-mentioned example.

In this state, Cu is sputtered to form the wiring conductors 28 and 28' as an electrode and a wiring layer so as to bury the via hole 27 and the trench 29 as shown in the figure. In this event, also on a surface of the porous coated insulative film 43, the Cu layer is formed to a thickness of about 100µm.

Then, using buffered hydrofluoric acid containing 35% ethylene glycol as an etchant, Cu is removed by lift-off. Specifically, the porous coated insulative film 43 is dissolved and removed in about 2 minutes by the etchant. In the etching of the porous coated insulative film 43, the Cu layer on the porous coated insulative film 43 is also removed. As a result, the Cu layer remains only in the trench 29 and the via hole 27 so that the electrode and wiring 28 and 28' are formed.

In the illustrated structure, the surface nitrided film 42 on the barrier layer 25 serves as an etching stopper against the etchant and, by the use of the porous coated insulative film 43, the etching can be quickly carried out. The surface nitrided film 42 with a thickness of 3 to 5nm can bear the hydrofluoric acid for 2 to 5 minutes. Further, by covering the barrier layers 21 and 25 with the nitrided films 41 and 42, it is possible to prevent the SiCO coating films forming the barrier layers 21 and 25 from adsorbing water to produce an organic compound.

Further, using the buffered hydrofluoric acid containing the ethylene glycol as the etchant as described above, it is also possible to prevent a surface of Cu forming the electrode or wiring 28 from being roughened.

In the embodiment described above, since the wiring can be formed by performing the lift-off by the chemical technique (hereinafter referred to as the chemical lift-off), the formation of the wiring can be carried out without using conventionally used CMP (chemical mechanical polishing). Since the chemical lift-off can be performed at a cost of about 1/10 as compared with that of CMP, it is possible to significantly reduce the cost in the manufacturing process. Further, since the chemical lift-off can achieve the lift-off uniformly over a wide range as compared with CMP, there is an advantage in that it is also applicable to large-area semiconductor devices.

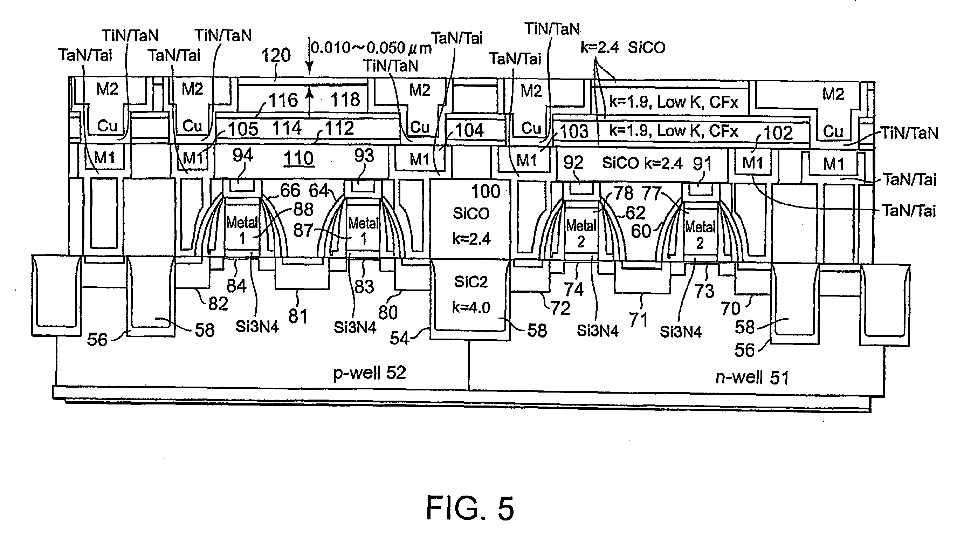

Referring to Fig. 5, a description will be given of a specific example of a semiconductor device having interlayer insulating films including fluorocarbon (CFx) films and coated insulative films. The illustrated semiconductor device comprises an n-well 51 formed by implanting P (phosphorus) into a semiconductor substrate (herein, a silicon substrate) and a p-well 52 formed by implanting B (boron) into the semiconductor substrate, wherein shallow trenches (STs) 54 and 56 are provided between the n-well 51 and the p-well 52 and in the respective n-well 51 and p-well 52 and an inner wall and a bottom portion of each of the shallow trenches 54 and 56 are covered with an insulating thin film. In each of the shallow trenches 58 covered with the insulating thin film, an insulating film 58 made of SiO₂ is buried.

The insulating film 58 is formed by coating the above-mentioned SiCO coating film and then modifying the SiCO coating film to SiO₂ by a heat treatment at a high temperature of about 900ºC. According to the technique of forming the insulating film 58 by coating the coated insulative film and then modifying it, since the coated insulative film itself has liquidity in the coated state, it maintains the surface flatness regardless of unevenness of the semiconductor substrate. Therefore, even after modified to SiO₂ by the heat treatment, the SiO₂ maintains the surface flatness. Thus, there is no need to flatten the SiO₂ surface after the modification by CMP or the like.

On the other hand, if a SiO₂ film is directly formed on an uneven surface of a semiconductor substrate as conventional, since unevenness of the surface of the semiconductor substrate is, as it is, reflected as unevenness of a surface of the SiO₂ film, it is necessary to flatten the surface of the SiO₂ film by CMP. According to the technique of forming the SiO₂ film by modifying the SiCO coating film as in this invention, since flattening by CMP is not necessary, it is possible to significantly simplify the manufacturing processes of the semiconductor device.

In the illustrated example, two p-type MOS transistors 60 and 62 are formed in the n-well 51 surrounded by the shallow trenches 54 and 56 and two n-type MOS transistors 64 and 66 are formed in the p-well 52 surrounded by the shallow trenches 54 and 56. Specifically, in the n-well 51, the MOS transistors 60 and 62 have p-type element regions 70, 71, and 72 formed by implanting boron or the like after burying SiO₂ in the shallow trenches 54 and 56, gate insulating films 73 and 74 each in the form of a silicon nitride film (Si₃N₄), and gate electrodes 77 and 78 formed of a metal. Side walls of the gate insulating films 73 and 74 and the gate electrodes 77 and 78 of the illustrated MOS transistors 60 and 62 are covered with an insulating film.

On the other hand, the n-type MOS transistors 64 and 66 formed in the p-well 52 have n-type element regions 80, 81, and 82 formed by implanting arsenic or the like, gate insulating films 83 and 84 each in the form of a silicon nitride film, and gate electrodes 87 and 88. Side walls of the gate insulating films 83 and 84 and the gate electrodes 87 and 88 are also covered with an insulating film.

Further, gate electrode wirings 91, 92, 93, and 94 are respectively formed on the gate electrodes 77, 78, 87, and 88 of the MOS transistors 60, 62, 64, and 66. Herein, the gate electrode wirings 91 to 94 are formed on the gate electrodes 77, 78, 87, and 88 which are exposed by, after coating and baking a first coated insulative film 100 in the form of the above-mentioned SiCO coating film, selectively etching the first coated insulative film 100. Herein, the SiCO coating film forming the first coated insulative film 100 has a dielectric constant k of 2.4.

Further, wiring layers 102, 103, 104, and 105 are selectively provided on the first coated insulative film 100 and these wiring layers 102, 103, 104, and 105 are electrically connected to the element regions 70, 72, 80, and 82 of the MOS transistors 60, 62, 64, and 66, respectively. That is, the first coated insulative film 100 forms a first interlayer insulating film.

In this case, the wiring layers 102, 103, 104, and 105 are buried in a second coated insulative film 110 formed by a SiCO coating film. That is, the wiring layers 102, 103, 104, and 105 are formed in regions obtained by selectively etching the second coated insulative film 110 and are electrically connected to the element regions 70, 72, 80, and 82. The second coated insulative film 110 formed by the SiCO coating film serves as a second interlayer insulating film and has a dielectric constant k of 2.4.

In the illustrated example, a first barrier layer 112 is formed on the second coated insulative film 110 and the wiring layers 102 to 105 and this first barrier layer 112 is also formed by a SiCO coating film having a dielectric constant k of 2.4.

Then, on the barrier layer 112, a fluorocarbon (CFx) film having a very low dielectric constant k of 1.9 is formed as a third interlayer insulating film 114. In this manner, the dielectric constant k of the third interlayer insulating film 114 formed by the fluorocarbon film is lower than the dielectric constant k of the SiCO coating film forming the barrier layer 112.

A second barrier layer 116, a fourth interlayer insulating film 118, and a third barrier layer 120 are formed in this order on the third interlayer insulating film 114. Herein, the second and third barrier layers 116 are each formed by a SiCO coating film having a dielectric constant k of 2.4 like the first barrier layer 112, while the fourth interlayer insulating film 118 is formed by a fluorocarbon (CFx) film.

The first to third barrier layers 112, 116, and 120 are formed by spin-coating a SiCO coating solution and then baking it at a relatively low temperature of about 400ºC. The third and fourth interlayer insulating films 114 and 118 are formed by CVD in a microwave-excited plasma processing apparatus. As in the illustrated example, when the third barrier layer 120 is formed by spin-coating the SiCO coating film, it is possible to obtain the third barrier layer 120 with a very uniform thickness. This is because a coated insulative film in the form of a SiCO coating film can be controlled in a thickness range of 10 to 50nm.

As illustrated, the wiring layers 103, 104, and 105 are electrically connected to Cu wirings formed in trenches each formed through the first to third barrier layers 112, 116, and 120 and the third and fourth interlayer insulating films 114 and 118. The interlayer insulating films 114 and 118 each formed by the fluorocarbon (CFx) film are provided with a barrier film against Cu, thereby preventing diffusion of Cu into the interlayer insulating films. It has also been found that the first to third barrier layers 112, 116, and 120 each formed by the SiCO coating film form effective barriers against Cu and fluorine.

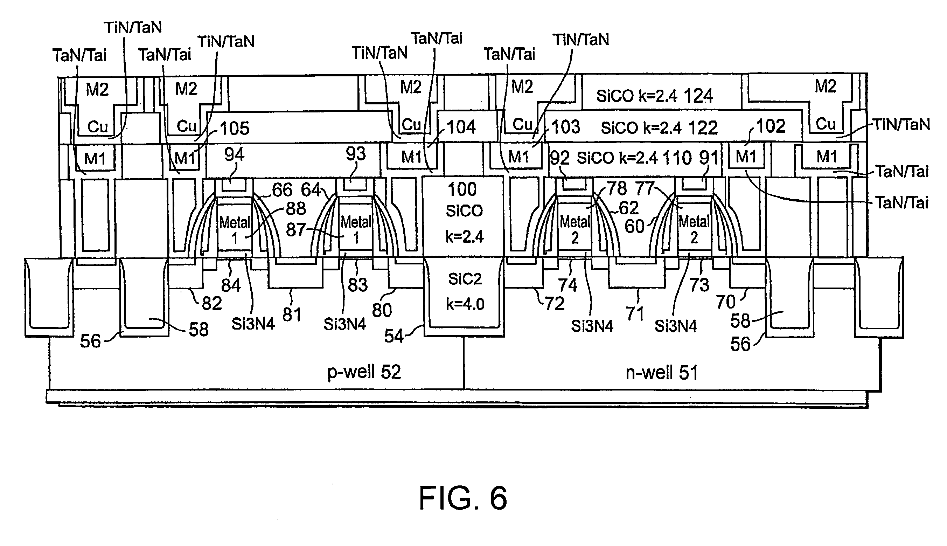

Referring to Fig. 6, a description will be given of a specific example of a semiconductor device having interlayer insulating films each formed by a coated insulative film. In Fig. 6, portions designated by the same reference numerals as those in Fig. 5 are those portions common to Fig. 5. Specifically, the semiconductor device shown in Fig. 6 is the same as that of Fig. 5 in that a SiCO coating film is used as each of first and second interlayer insulating films 100 and 110, but differs from the semiconductor device of Fig. 5 in that third and fourth interlayer insulating films 122 and 124 formed on the second interlayer insulating film 110 are each also formed by a coated insulative film in the form of a SiCO coating film. In this structure, since the third and fourth interlayer insulating films 122 and 124 are each formed by the SiCO coating film, the barrier layers 112, 116, and 120 shown in Fig. 5 become unnecessary.

In this structure, since the first to fourth interlayer insulating films 100, 110, 122, and 124 are all formed by the SiCO coating films each having a dielectric constant k of 2.4, the dielectric constant k slightly increases as compared with the case where the fluorocarbon films each having a dielectric constant k of 1.9 are used as shown in Fig. 5, but there is an advantage that the processes of forming the fluorocarbon films can be omitted and thus the manufacturing processes can be simplified.

In the examples shown in Figs. 5 and 6, the description has been given assuming that the same SiCO coating films are used as the first to fourth interlayer insulating films 100, 110, 122, and 124, but this invention is by no means limited thereto and it is also possible to form them using mutually different types of SiCO coating films. For example, an interlayer insulating film, to which high etching rate is required, may be formed by a porous SiCO coating film or a composition gradient film in which the composition changes in its thickness direction.

In the above-mentioned embodiments, the examples are shown in which use is made of the coating film with the composition of (CH₃SiO_{3/2})ₓ(SiO₂)₁₋ₓ (where 0≤x≤1.0). However, in this formula, instead of CH₃SiO_{3/2}, use may be made of, for example, (CH₃)₂SiO, (CH₃)₃SiO_{1/2}, or the like, or a mixture thereof. That is, this invention is characterized by using a coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0). Herein, the suffix of first "O" in the general formula is 2-(n/2).

### Industrial Applicability

As described above, this invention uses coated insulative films having a dielectric constant of 2.5 or less as part of or all of interlayer insulating films and thus is not only applicable to various semiconductor devices, liquid crystal display devices, and the like including interlayer insulating films, but also applicable to various wiring structures and electronic devices including interlayer insulating films.

## Claims

1. An interlayer insulating film provided between a lower electrode or wiring layer and an upper wiring layer, said interlayer insulating film including, at least at a part thereof, a coated insulative film having a dielectric constant k of 2.5 or less.

2. An interlayer insulating film provided between a lower electrode or wiring layer and an upper wiring layer, said interlayer insulating film including a fluorocarbon film as a main insulating film, wherein a coated insulative film is provided on said fluorocarbon film.

3. An interlayer insulating film according to claim 2, wherein said fluorocarbon film contains F and C in a range of 0.8 to 1.1 in atomic ratio F/C.

4. An interlayer insulating film according to claim 2 or 3, wherein said fluorocarbon film has a dielectric constant k of 1.8 to 2.2.

5. An interlayer insulating film according to any one of claims 2 to 4,
wherein said fluorocarbon film has a thickness of 50 to 500nm.

6. An interlayer insulating film according to any one of claims 2 to 5,
wherein said coated insulative film has a thickness that is 1 /10 or less of that of said fluorocarbon film.

7. An interlayer insulating film according to any one of claims 2 to 5,
wherein said coated insulative film has a thickness that is 1/5 or less of that of said fluorocarbon film.

8. An interlayer insulating film according to any one of claims 2 to 5,
wherein said coated insulative film has a thickness that is 1/3 or less of that of said fluorocarbon film.

9. An interlayer insulating film according to any one of claims 2 to 8,
wherein said fluorocarbon film is formed by CVD using at least one kind of gas containing C and F in a plasma generated using at least one of an Ar gas, a Xe gas, and a Kr gas.

10. An interlayer insulating film according to claim 1, wherein said coated insulative film is a main insulating film.

11. An interlayer insulating film according to any one of claims 2 to 9, wherein said coated insulative film has a dielectric constant k of 2.5 or less.

12. An interlayer insulating film according to any one of claims 1 to 11, wherein said coated insulative film has a surface flatness of 1 nm or less in Ra and 20nm or less in peak-to-valley value.

13. An interlayer insulating film according to any one of claims 1 to 12, wherein said coated insulative film contains Si, C, and O so that O>Si>1/2C in atomic ratio.

14. An interlayer insulating film according to any one of claims 1 to 13, wherein said coated insulative film is a film obtained by drying and baking a liquid coating film containing at least one of a metal organic compound and a metal inorganic compound and a solvent.

15. An interlayer insulating film according to any one of claims 1 to 13, wherein said coated insulative film is a film obtained by drying and baking at 600ºC or less a liquid coating film containing at least one of a metal organic compound and a metal inorganic compound and a solvent.

16. An interlayer insulating film according to any one of claims 1 to 13, wherein said coated insulative film is a film obtained by drying and baking at 400ºC or less a liquid coating film containing at least one of a metal organic compound and a metal inorganic compound and a solvent.

17. An interlayer insulating film according to any one of claims 1 to 16, wherein said coated insulative film is an insulator film which has a main skeleton specified by a repetition unit of SiO and which has a composition comprising one kind or two or more kinds of oxides expressed by a general formula of ((CH₃)ₙSiO_{2-n/2})ₓ(SiO₂)₁₋ₓ (where n=1 to 3 and x≤1).

18. An interlayer insulating film according to any one of claims 1 to 17, wherein said coated insulative film has a nitride surface layer formed by nitriding a surface thereof.

19. A multilayer wiring structure having the interlayer insulating film according to any one of claims 1 to 18, said multilayer wiring structure comprising at least one of a via and a trench in said interlayer insulating film, a conductor layer buried in said at least one of said via and said trench, and a barrier layer provided around said conductor layer.

20. A multilayer wiring structure having an interlayer insulating film,
wherein said interlayer insulating film includes an insulator film obtained from a coating film comprising one kind or two or more kinds of oxides expressed by a general formula of ((CH₃)ₙSiO_{2-n/2})ₓ(SiO₂)₁₋ₓ (where n=1 to 3 and x≤1).

21. A multilayer wiring structure according to claim 20, wherein said interlayer insulating film comprises said insulator film and a fluorocarbon film (CFx).

22. A multilayer wiring structure according to claim 20, wherein said interlayer insulating film is formed by said insulator film.

23. A multilayer wiring structure including a plurality of interlayer insulating films, wherein at least one of said plurality of interlayer insulating films includes an insulator film obtained from a coating film comprising one kind or two or more kinds of oxides expressed by a general formula of ((CH₃)ₙSiO_{2-n/2})ₓ(SiO₂)₁₋ₓ (where n=1 to 3 and x≤1).

24. A method of manufacturing an interlayer insulating film, said method comprising coating a liquid material containing one kind or two or more kinds of oxides expressed by a general formula of ((CH₃)ₙSiO_{2-n/2})ₓ(SiO₂)₁₋ₓ (where n=1 to 3 and x≤1) and drying a film thus coated, thereby forming the interlayer insulating film including an insulator film having a dielectric constant k of 2.5 or less.

25. A manufacturing method of forming a multilayer wiring structure including an interlayer insulating film, wherein a step of forming said interlayer insulating film comprises a step of coating a liquid material containing one kind or two or more kinds of oxides expressed by a general formula of ((CH₃)ₙSiO_{2-n/2})ₓ(SiO₂)₁₋ₓ (where n=1 to 3 and x≤1) and drying a film thus coated, thereby forming said interlayer insulating film including an insulator film having a dielectric constant k of 2.5 or less.

26. An electronic device including an interlayer insulating film, wherein said interlayer insulating film is an insulator film obtained from a coating film comprising one kind or two or more kinds of oxides expressed by a general formula of ((CH₃)ₙSiO_{2-n/2})ₓ(SiO₂)₁₋ₓ (where n=1 to 3 and x≤1).

27. A method of manufacturing an electronic device including an interlayer insulating film, wherein a step of forming said interlayer insulating film comprises a step of coating a liquid material containing one kind or two or more kinds of oxides expressed by a general formula of ((CH₃)ₙSiO_{2-n/2})ₓ(SiO₂)₁₋ₓ (where n=1 to 3 and x≤1) and drying a film thus coated, thereby forming said interlayer insulating film including an insulator film having a dielectric constant k of 2.5 or less.
